# EUROPEAN PATENT SPECIFICATION

(11) **EP 2 430 531 B1**
(45) Date of publication and mention of the grant of the patent: **04.12.2019**
(21) Application number: 10767899.7
(22) Date of filing: 26.04.2010
(51) Int. Cl.: H03F 1/32, H03F 3/24, G06F 9/445

(54) **REMOTELY RECONFIGURABLE POWER AMPLIFIER SYSTEM AND METHOD**
FERNKONFIGURIERBARES STROMVERSTÄRKUNGSSYSTEM UND VERFAHREN DAFÜR
SYSTÈME D'AMPLIFICATION DE PUISSANCE POUVANT ÊTRE RECONFIGURÉ À DISTANCE ET PROCÉDÉ

(30) Priority: 24.04.2009 US 172642 P
(43) Date of publication of application: 21.03.2012
(73) Proprietor: Dali Systems Co. Ltd., Grand Cayman (KY)
(72) Inventor: STAPLETON, Shawn, P., Burnaby, V5A 4C6 (CA); LEE, Albert, S., San Mateo, CA 94402 (US)
(74) Representative: Diehl & Partner GbR
(86) International application number: PCT/US2010/032453
(87) International publication number: WO 2010/124297

(56) References cited:
- WO-A1-97/48181
- WO-A1-2008/154077
- WO-A2-2008/078195
- US-A- 5 920 808
- US-A- 6 055 418
- US-A1- 2005 262 498
- US-A1- 2006 012 426
- US-A1- 2006 012 427
- US-A1- 2006 270 366

## Description

### CROSS REFERENCE TO RELATED APPLICATION

This application claims the benefit of U.S. Provisional Application S.N. 61/172,642 filed 4/24/2009.

### BACKGROUND OF THE INVENTION

### 1. FIELD OF THE INVENTION

The present invention generally relates to wireless communication systems using complex modulation techniques. More specially, the present invention relates to single and multi-carrier power amplifier systems that contain a microprocessor or other similar digital components, such as a Field Programmable Gate Array (FPGA) or Application Specific Integrated Circuit (ASIC).

### 2. THE PRIOR ART

A wideband mobile communication system using complex modulation techniques such as wideband code division access (WCDMA) and orthogonal frequency division multiplexing (OFDM) has a large peak-to-average power ratio (PAPR) and requires a high linearity of the base-station's power amplifiers (PA). The conventional feedforward linear power amplifier (FFLPA) has been widely utilized due to its excellent linearity performance in spite of poor power efficiency.

In order to overcome this poor efficiency, digital baseband predistortion (PD) has been demonstrated due to the recent advances in digital signal processors. A Doherty power amplifier (DPA) has also been applied to these linearization systems to maximize the power efficiency. The variation of the linearity performance of the amplifier due to the environment changing such as temperature and the asymmetric distortion of the output signal of the amplifier resulting from memory effects also needs to be compensated.

Conventional high power amplifiers (HPA), FFLPA, and DPA are known to fail frequently with mean time between failures (MTBF) from a few months to a few years. Low power efficiency means most of the energy is dissipated in the form of heat. Since most electronic components are known to be vulnerable to thermal damage, this significant thermal heat generated by the conventional PA systems is generally perceived to be one of the main cause of PA failures.

A failed PA would ordinarily cause the related base-station, repeater, or other transmission systems to stop functioning. Since a typical mobile operator or service provider depends on its voice and/or data traffic for revenues, a failed PA could be costly to its mobile operator in terms of loss revenue and questionable radio network reliability. Currently, conventional PA systems have local alarm features such as lights, audio indicators, displays, and etc. that signal a system failure. Mobile operators often have to react to such failures by sending technicians to replace the failed PAs after the failures were discovered in their radio networks. In some cases, mobile operators would measure a radio network technician's career performance in terms of "seconds" of a base-station or network downtime. In such cases, those network technicians are typically incentivized with cash bonus compensation to replace failed PA systems as soon as the latter are discovered. In other cases, some mobile operators implement a pre-emptive policy of replacing all PA systems after well less than the expected product lifetime, even though the PA systems were functioning perfectly well. This policy, of course, can be wasteful and inefficient.

Aside from PA failures, rapid advancements in mobile communications have also induced rapid changes in mobile communication systems such as modulation scheme evolutions, communication equipment firmware updates, radio frequency front-end systems enhancements, and etc. Conventional digital baseband PD systems are usually tailored to a specific wireless modulation scheme, such as CDMA, CDMA2000 EVDO, UMB, OFDM, WCDMA, TDS-CDMA, GSM, EDGE, etc., with a specific set of specifications such as PAPR, error vector magnitude (EVM), adjacent channel power ratio (ACPR), operating radio frequency, bandwidth, and etc. Usually, any updates or changes in specifications require an update of digital baseband PD systems, or in some cases, a wholesale replacement of the entire PA system. The high cost and labor intensity of making such updates and changes have driven up significantly the cost of capital equipment upgrades, and in turn, reduced the mobile operators' desire to deploy most state-of-art wireless technology in their radio networks for the end users among the general public.

WO 97/48181 A1 discloses a reconfigurable power delivery system for use in a radio frequency system with a means of failure detection which is communicated to a remote system controller.

WO 2008/078195 A2 discloses a software programmable capable wireless communication system which monitors amplitude-amplitude and amplitude-phase distortions of the power amplifier.

US 2006/012427 A1 discloses a remotely reconfigurable power amplifier in a communication system based on monitored coefficients of amplitude-amplitude and amplitude-phase curves of the power amplifier.

Hence, a need remains for remotely monitoring the power amplifier performance and providing an advance indication or prediction when a power amplifier will fail. A need also remains for enabling a power amplifier already deployed in radio networks to be upgraded or enhanced via software upgrades, especially those managed remotely. Such features would save mobile operators significant operating and capital expenses relating to radio networks maintenance and PA replacement. If such an arrangement existed, mobile operators could also deploy the latest wireless technology for the general end users while preserving their existing capital investments.

### SUMMARY OF THE INVENTION

Accordingly, the present invention has been made in view of the above problems, and it is an object of the present invention to provide an efficient and effective method of remotely communicating with, monitoring and upgrading power amplifier systems. To achieve the above objectives, according to the present invention, remote connectivity such as internet, Ethernet, wireless, WiFi, WiMAX, cellular, local area networks (LAN), wide area networks (WAN), Bluetooth, and etc. (collectively, the "Remote Media"), is added to the power amplifier systems.

The scope of the invention is defined in the appended claims. Any reference to "embodiment(s)", "example(s)" or "aspect(s) of the invention" in this description not falling under the scope of the claims should be interpreted as illustrative example(s) for understanding the invention.

The present invention is applicable to any power amplifier systems that have software defined radio (SDR) capability, such as digital signal processing, digital PD, and etc., such as disclosed in US 2008/0265996 A1. In an embodiment, a communication link is established between a microprocessor (or other digital components) of a PA system and a remote computer terminal or command centre through the Remote Media.

Depending upon the embodiment, the microprocessor (or other digital components such as digital sensors) inside the PA systems is configured to measure coefficients of the PA amplitude-amplitude, AM-AM, and amplitude- phase AM-PM curves, and measure the operating conditions of functioning PA systems such as temperature, gain, current, voltage, time, time-delay, in-phase and/or quadrature baseband signal (I and Q Signals), coefficients of the PD look-up table and/or algorithms, frequency, bandwidth, transistor junction temperatures, non-linearities, and other tangible physical characteristics. In an embodiment, the values measured by microprocessor are recorded, processed, and/or transmitted real-time or non-real-time, and can be stored in the microprocessor's onboard or external memory. Any suitable networking protocol, such as TCP/IP, and standard microprocessor interfacing features are implemented to transmit or receive information to-and-from the microprocessor (or other digital components) and the remote system. The PA's microprocessor then communicates the monitored data to a remote host such as a web server or computing mainframe to synthesize, digest, monitor, display, evaluate, calculate, compute, update, compare, send, direct, redirect, download, upload, etc. the data collected from the microprocessor(s) in the PA system(s).

More specifically, failing PA systems are known to exhibit abnormal electrical current characteristics. A Field Programmable Gate Array (FPGA) or Application Specific Integrated Circuit (ASIC) that incorporates a processor, such as a Power PC or Microblaze, controls the data flow to and from the Remote Media. In terms of standard networking protocol, an Ethernet MAC can be used to send and receive packets using TCP/IP networking. A computer network server, or host, such as a web server can be used to establish the remote communication to the power amplifier, while allowing the end user or an automated management program to monitor the PA status. In the case of remote upgrading the software of the PA system, the remote server can upload a software patch or a complete new operating system or kernel via the Remote Media to the microprocessor and perform a remote restart or reboot of the PA system, thereby remotely upgrading the system .

### BRIEF DESCRIPTION OF DRAWINGS

Further objects and advantages of the invention can be more fully understood from the following detailed description taken in conjunction with the accompanying drawings in which:
Figure 1 is a block diagram showing a remotely monitorable and reconfigurable power amplifier system for base-station and repeater applications.
Figure 2 is a flow chart of a method for communicating with the power amplifier of the present invention.
Figure 3 is a block diagram showing a remotely reconfigurable digital hybrid mode power amplifier system for base station and repeater applications according to another embodiment of the present invention.
Figure 4 is a block diagram showing another embodiment of a remotely reconfigurable digital hybrid mode power amplifier system.

### DETAILED DESCRIPTION OF THE INVENTION

The present invention applies standard networking protocol and interface procedures to power amplifier systems that have digital operations capability through microprocessors in the PA systems. In particular, the invention provides system operators the ability to remotely reconfigure PA's within their network to accommodate improvements in the performance of the PA. The remote connection enables upgrades, adjustments, and/or changes as requested by the mobile operators and/or service providers. The remote connection also enables remote monitoring of the performance of the power amplifier. The method provided by the present invention is referred as the remotely reconfigurable power amplifier (RRPA) system hereafter.

Preferred embodiments of the RRPA system according to the present invention will now be described in detail with reference to the accompanying drawings.

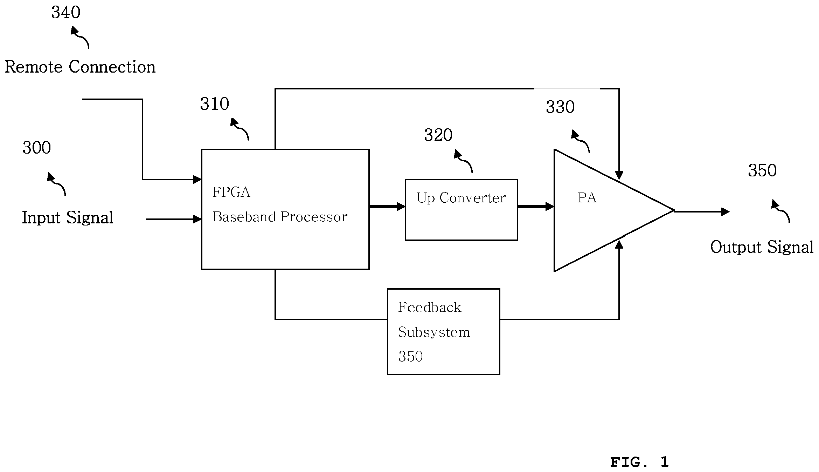

Referring first to Figure 1, there is shown therein in block diagram form an embodiment of an RRPA system in accordance with the inventon. The RRPA system for base-station applications receives a multi-carrier digital signal 300 at the input and generates an RF signal 350 at the output, respectively. In an embodiment, the RRPA system comprises an FPGA-based digital subsystem 310, an up-converter subsystem 320 and a power amplifier subsystem 330. It will be appreciated by those skilled in the art that the subsystem 310 need not be FPGA-based, and that term is used herein merely for clarity and simplicity.

In an embodiment, the FPGA-based digital subsystem 310 comprises a field programmable gate array (FPGA), digital-to-analog converters (DACs), analog-to-digital converters (ADCs), and a phase-locked loop (PLL). In the FPGA subsystem 310, crest factor reduction (CFR), digital filtering and predistortion (PD) are implemented, and the FPGA subsystem 310 is SDR-capable. An input/output 340 into the FPGA-subsystem provides bidirectional communication with a remote host, not shown, which can be a web server or other network server, and other suitable hosting system. Feedback subsystem 350 provides to the FPGA subsystem 310 data regarding the operating characteristics of the PA, including temperature, gain, current, voltage, time, time-delay, in-phase and/or quadrature baseband signal (I and Q Signals), coefficients of the PA amplitude-amplitude (AM-AM) and/or amplitude-phase (AM-PM) curves, coefficients of the PD look-up table and/or algorithms, frequency, bandwidth, transistor junction temperatures, non-linearities, and other tangible physical characteristics.

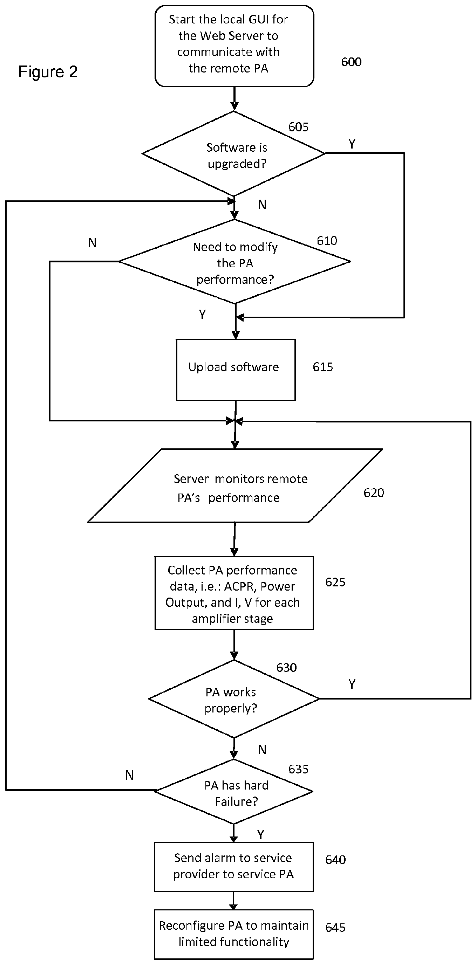

FIGURE 2 shows in flow chart form a method for managing communications between a host and a power amplifier in accordance with the present invention. At step 600, the local GUI is started at the host to enable the host/web server to communicate with the PA. Then, at step 605, a check is made to determine whether the PA software needs to be updated. If not, the process advances to step 610 and check is made to determine whether the PA's performance needs to be modified. If the answer is yes at either step 605 or 610, the process advances to step 615 and appropriate software is uploaded from the server to the PA via the communications link 340.

If the answer at both steps 605 and 610 is no, the process jumps to step 620, and the server monitors the PA's performance. In particular, as shown at 625, the server collects, through link 340, PA performance data which, depending upon the particular implementation, can comprise ACPR, temperature, gain, current, voltage, time, time-delay, in-phase and/or quadrature baseband signal (I and Q Signals), coefficients of the PA amplitude-amplitude (AM-AM) and/or amplitude-phase (AM-PM) curves, coefficients of the PD look-up table and/or algorithms, frequency, bandwidth, transistor junction temperatures, non-linearities, and other tangible performance characteristics of the PA such as ACPR, temperature, gain, current, voltage, time, time-delay, and in-phase or quadrature baseband signal (I and Q Signals). A check is then made at step 630 to determine whether the PA is working properly. If the PA is working properly, the process loops back to step 620, and monitoring continues. If the answer is no, a check is made at step 635 to determine whether a hard failure has occurred. If not, the process loops back to step 610 to determine whether the PA's performance needs to be modified in accordance with the data received from the PA. If a hard failure has occurred, an alarm signal is sent at step 640 to cause a repair/replacement to occur. Either alternatively or in addition to the alarm signal 640, and depending upon the PAs failure mode, the power amplifier may be remotely reconfigured as shown at step 645 to provide reduced functionality relative to normal operation at least until a repair or replacement can be made. Those skilled in the art will recognize that steps 640 and 645 can occur in either order, or substantially concurrently, and neither necessarily depends upon the other.

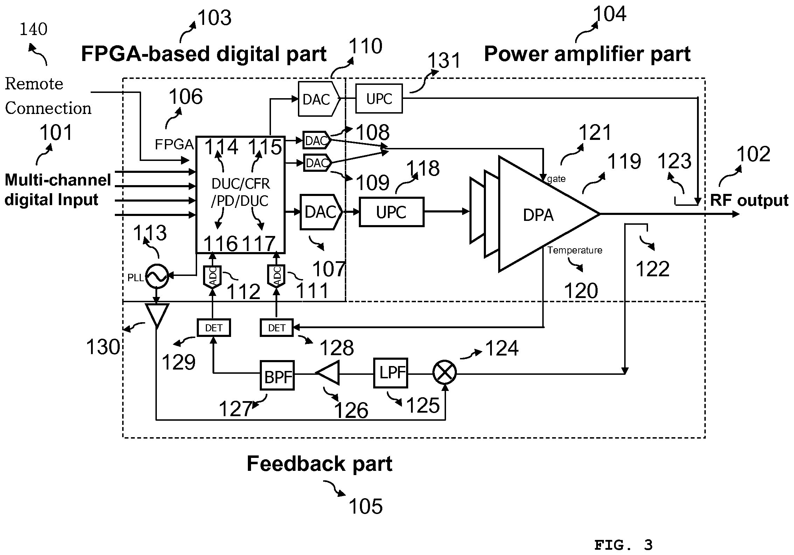

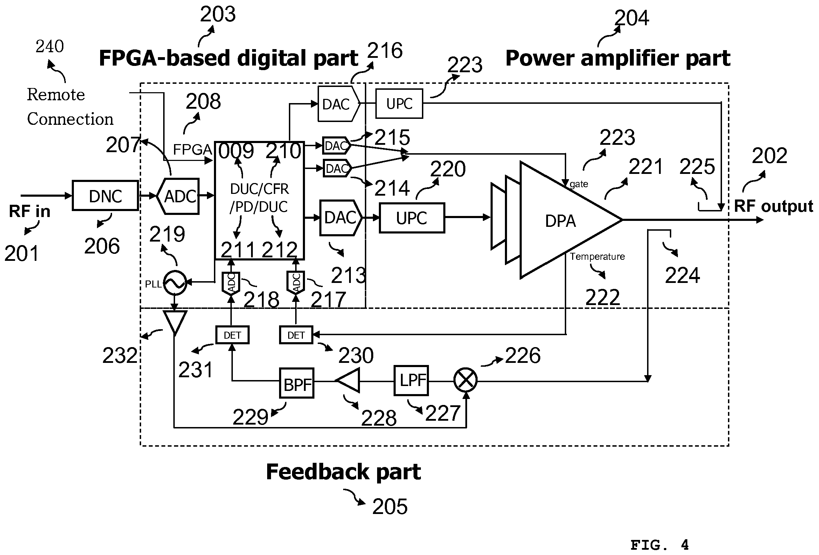

Referring next to Figures 3 and 4, two alternative embodiments of remotely reconfigurable digital hybrid mode power amplifier systems are shown in block diagram form. Such power amplifier systems are particularly suited to use for base station and repeater applications according to an embodiment of the present invention. In each case, the FPGA-based subsystem, PA subsystem and Feedback subsystem are shown as 103/203, 104/204 and 105/205 respectively. In Figure 3, a multi-channel input is illustrated, with remote connection 140 providing an I/O link to a remote server, not shown. In Figure 4, RF input 201 provides an input to a down-converter 206, and again a bi-directional link to a remote server is provided at remote connection 240. It can be appreciated that, in either case, the feedback subsystem is configured to provide to the FPGA-based subsystem appropriate data characterizing the performance of the PA.

As a result, it can be appreciated that the remotely reconfigurable DHMPA system of the present invention communicate with a remote host via any suitable link including the internet, thereby providing capabilities including, depending upon the embodiment, performance monitoring, early warning failure detection, software upgrades, reconfigurability to service providers specifications (i.e. # of carriers, modulation of carriers, frequency of carriers, Crest Factor Reduction, Error Vector Magnitude, ACPR, ...) and so forth.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

The claims of the present case follow on the next page. Figures 1-4 of the present case follow the claims of the present case.

## Claims

1. A method for remotely reconfiguring a power amplifier in a wireless communications system comprising the steps of:
providing a power amplifier in a wireless communications system having a microprocessor and software-defined radio capability,
providing a remote media link between a remote computer and the power amplifier to permit communications therebetween, iteratively monitoring (625) coefficients of amplitude-amplitude, AM-AM, and amplitude-phase, AM-PM, curves of the power amplifier,
comparing the iteratively monitored coefficients of amplitude-amplitude, AM-AM, and amplitude-phase, AM-PM, curves of the power amplifier to determine whether or not the power amplifier is working properly,
determining (635) an early warning of failure based on the compared coefficients of amplitude-amplitude, AM-AM, and amplitude-phase, AM-PM, curves of the power amplifier,
reporting (640) the early warning of failure to the remote computer, and
reconfiguring (645) the power amplifier as directed by the remote computer.

2. The method of claim 1 wherein the reconfiguring step (645) comprises uploading (615) at least one software patch.

3. The method of claim 1, wherein the reconfiguring step (645) comprises reconfiguring the power amplifier to operate with reduced functionality relative to normal operation.

4. The method of claim 1 further comprising iteratively monitoring at least one of in-phase and quadrature baseband signals, I and Q signals, coefficients of a predistortion look-up table, frequency, and bandwidth measurements of the power amplifier.

5. The method of claim 1, further comprising iteratively monitoring transistor junction temperatures.

6. The method of claim 1, further comprising detecting a failure of the power amplifier requiring repair or replacement via the remote computer, and wherein reconfiguring the power amplifier as directed by the remote computer is based on detecting the failure.

7. A reconfigurable power amplifier system for use in wireless communications systems comprising:
a power amplifier (330),
a communications link (340) adapted to communicate with a remote computer system,
at least one detector for iteratively monitoring coefficients of amlitude-amplitude, AM-AM, and amplitude-phase, AM-PM, curves of the power amplifier, and
a microprocessor (350) having software-defined radio capability and responsive to the at least one detector for communicating with the remote computer system via the communications link (340), wherein the microprocessor (350) is operable to compare the iteratively monitored coefficients of amplitude-amplitude, AM-AM, and amplitude-phase, AM-PM, curves of the power amplifier (330) to determine whether or not the power amplifier is working properly, determine an early warning of failure based on the compared coefficients of amplitude-amplitude, AM-AM, and amplitude-phase, AM-PM, curves of the power amplifier (330), and report the early warning of failure to the remote computer system, and wherein the microprocessor (350) is responsive to instructions from the remote computer system for reconfiguring the power amplifier (330) in response to the early warning of failure.

8. The reconfigurable power amplifier system of claim 7 wherein the instructions comprise providing a software patch to the microprocessor (350) via the communications link (340).

9. The reconfigurable power amplifier system of claim 7, wherein the instructions comprise reducing functionality of the power amplifier (330) relative to normal operation.

10. The reconfigurable power amplifier system of claim 7 wherein the instructions comprise uploading a new operating system to the microprocessor (350) and performing a remote restart of the reconfigurable power amplifier system (330), thereby remotely upgrading the reconfigurable power amplifier system (330).

11. The reconfigurable power amplifier system of claim 7 further comprising a multi-channel input configurable to interface with a plurality of base stations.

12. The reconfigurable power amplifier system of claim 11 wherein the multi-channel input is further configurable to interface with a plurality of repeater applications.

13. The reconfigurable power amplifier system of claim 7, wherein the detector further iteratively monitors transistor junction temperatures.

## Patentansprüche

1. Verfahren zum Remote-Rekonfigurieren eines Leistungsverstärkers in einem Drahtlos-Kommunikationssystem mit den Schritten:
Bereitstellen eines Leistungsverstärkers in einem Drahtlos-Kommunikationssystem mit einem Mikroprozessor und Software-definierter Radio-Eignung,
Bereitstellen eines Remote-Media-Links zwischen einem Remote-Computer und dem Leistungsverstärker zum Erlauben von Kommunikation zwischen diesen, iteratives Überwachen (625) von Koeffizienten von Amplitude-Amplitude (AM-AM)- und Amplitude-Phase (AM-PM)-Kurven des Leistungsverstärkers,
Vergleichen der iterativ überwachten Koeffizienten der Amplitude-Amplitude (AM-AM)- und Amplitude-Phase (AM-PM)-Kurven des Leistungsverstärkers zum Bestimmen, ob der Leistungsverstärker richtig arbeitet oder nicht,
Bestimmen (635) einer Früh-Fehlerwarnung auf der Grundlage der verglichenen Koeffizienten der Amplitude-Amplitude (AM-AM)- und Amplitude-Phase (AM-PM)-Kurven des Leistungsverstärkers,
Berichten (640) der Früh-Fehlerwarnung an den Remote-Computer, und
Rekonfigurieren (645) des Leistungsverstärkers wie von dem Remote-Computer angewiesen.

2. Verfahren nach Anspruch 1, wobei der Rekonfigurier-Schritt (645) das Hochladen (615) von wenigstens einem Software-Patch beinhaltet.

3. Verfahren nach Anspruch 1, wobei der Rekonfigurier-Schritt (645) das Rekonfigurieren des Leistungsverstärkers dahingehend beinhaltet, dass er mit im Vergleich zum normalen Betrieb verringerter Funktionalität arbeitet.

4. Verfahren nach Anspruch 1, ferner beinhaltend iteratives Überwachen von In-Phase- und Quadratur-Baseband-Signalen (I- und Q-Signalen), Koeffizienten einer Vorverzerrungs-Look-Up-Tabelle, Frequenz- oder Bandbreiten-Messungen des Leistungsverstärkers.

5. Verfahren nach Anspruch 1, ferner beinhaltend iteratives Überwachen von Transistor-Junction-Temperaturen.

6. Verfahren nach Anspruch 1, ferner beinhaltend Erfassen eines Versagens des Leistungsverstärkers, das seine Reparatur oder seinen Austausch erfordert, über den Remote-Computer, und wobei das Rekonfigurieren des Leistungsverstärkers wie vom Remote-Computer angewiesen auf der Grundlage des Versagens erfolgt.

7. Rekonfigurierbares Leistungsverstärkersystem zur Verwendung in Drahtlos-Kommunikationssystemen, mit:
einem Leistungsverstärker (330),
einem Kommunikations-Link (340), der dazu ausgebildet ist, mit einem Remote-Computersystem zu kommunizieren,
wenigstens einen Detektor zum iterativen Überwachen von Koeffizienten von Amplitude-Amplitude (AM-AM)- und Amplitude-Phase (AM-PM)-Kurven des Leistungsverstärkers, und
einem Mikroprozessor (350) mit Software-definierter Radio-Eignung und Ansprechen auf den wenigstens einen Detektor zum Kommunizieren mit dem Remote-Computersystem über den Kommunikations-Link (340), wobei der Mikroprozessor (350) dazu eingerichtet ist, die iterativ überwachten Koeffizienten der Amplitude-Amplitude (AM-AM)- und Amplitude-Phase (AM-PM)-Kurven des Leistungsverstärkers zu vergleichen, um zu bestimmen, ob der Leistungsverstärker richtig arbeitet oder nicht, auf der Grundlage der verglichenen Koeffizienten der Amplitude-Amplitude (AM-AM)- und Amplitude-Phase (AM-PM)-Kurven des Leistungsverstärkers (330) eine Früh-Fehlerwarnung zu bestimmen, und die Früh-Fehlerwarnung an das Remote-Computersystem zu berichten, und wobei der Mikroprozessor (350) auf Anweisungen von dem Remote-Computersystem zum Rekonfigurieren des Leistungsverstärkers (330) infolge der Früh-Fehlerwarnung anspricht.

8. Rekonfigurierbares Leistungsverstärkersystem nach Anspruch 7, wobei die Anweisungen beinhalten, einen Software-Patch für den Mikroprozessor (350) über den Kommunikations-Link (340) bereitzustellen.

9. Rekonfigurierbares Leistungsverstärkersystem nach Anspruch 7, wherein the instructions comprise reducing functionality of the power amplifier (330) relative to normal operation.

10. Rekonfigurierbares Leistungsverstärkersystem nach Anspruch 7, wobei die Anweisungen beinhalten, ein neues Betriebssystem für den Mikroprozessor (350) hochzuladen und einen Remote-Neustart des rekonfigurierbaren Leistungsverstärkers (330) durchzuführen, wodurch ein Remote-Aktualisieren des rekonfigurierbaren Leistungsverstärkersystems (330) erfolgt.

11. Rekonfigurierbares Leistungsverstärkersystem nach Anspruch 7, ferner beinhaltend einen Mehrkanal-Eingang, der dazu konfigurierbar ist, sich mit mehreren Basisstationen zu verbinden.

12. Rekonfigurierbares Leistungsverstärkersystem nach Anspruch 11, wobei der Mehrkanal-Eingang ferner dazu konfigurierbar ist, sich mit mehreren Repeater-Geräten zu verbinden.

13. Rekonfigurierbares Leistungsverstärkersystem nach Anspruch 7, wobei der Detektor ferner iterativ Transistor-Junction-Temperaturen überwacht.

## Revendications

1. Procédé pour reconfigurer à distance un amplificateur de puissance dans un système de communication sans fil comprenant les étapes de :
fourniture d'un amplificateur de puissance dans un système de communication sans fil ayant un micro-processeur et une capacité de radio logicielle,
fourniture d'un lien multimédia à distance entre un ordinateur distant et l'amplificateur de puissance pour permettre des communications entre ceux-ci, surveillance itérative (625) de coefficients de courbes amplitude-amplitude, AM-AM, et amplitude-phase, AM-PM, de l'amplificateur de puissance,
comparaison des coefficients surveillés de manière itérative des courbes amplitude-amplitude, AM-AM, et amplitude-phase, AM-PM, de l'amplificateur de puissance pour déterminer si l'amplificateur de puissance fonctionne correctement ou non,
détermination (635) d'une défaillance précoce basée sur les coefficients comparés des courbes amplitude-amplitude, AM-AM, et amplitude-phase, AM-PM, de l'amplificateur de puissance,
signalement (640) de la défaillance précoce à l'ordinateur distant, et
reconfiguration (645) de l'amplificateur de puissance tel qu'indiqué par l'ordinateur distant.

2. Procédé selon la revendication 1, dans lequel l'étape de reconfiguration (645) comprend une étape de téléchargement (615) d'au moins un correctif logiciel.

3. Procédé selon la revendication 1, dans lequel l'étape de reconfiguration (645) comprend une reconfiguration de l'amplificateur de puissance pour fonctionner avec des fonctionnalités réduites par rapport à un fonctionnement normal.

4. Procédé selon la revendication 1, comprenant en outre une surveillance itérative d'au moins un de signaux en bande de base en phase et en bande de base en quadrature, de signaux I et Q, de coefficients d'une table de correspondance de prédistortion, de fréquence et de mesures de la largeur de bande de l'amplificateur de puissance.

5. Procédé selon la revendication 1, comprenant en outre une surveillance itérative de températures de jonction de transistors.

6. Procédé selon la revendication 1, comprenant en outre une détection d'une défaillance de l'amplificateur de puissance nécessitant une réparation ou un remplacement via l'ordinateur distant, et dans lequel la reconfiguration de l'amplificateur de puissance telle qu'indiquée par l'ordinateur distant est basée sur la détection de la défaillance.

7. Système d'amplification de puissance reconfigurable pour une utilisation dans des systèmes de communication sans fil comprenant :
un amplificateur de puissance (330),
un lien de communications (340) adapté pour communiquer avec un système informatique à distance,
au moins un détecteur pour surveiller de manière itérative des coefficients de courbes amplitude-amplitude, AM-AM, amplitude-phase, AM-PM, de l'amplificateur de puissance, et
un micro-processeur (350) ayant une capacité de radio logicielle et adapté à l'au moins un détecteur pour communiquer avec le système informatique à distance via le lien de communications (340), le micro-processeur (350) étant utilisable pour comparer les coefficients surveillés de manière itérative des courbes amplitude-amplitude, AM-AM, amplitude-phase, AM-PM, de l'amplificateur de puissance (330) pour déterminer si l'amplificateur de puissance fonctionne correctement ou non, pour déterminer une défaillance précoce basée sur les coefficients comparés des courbes amplitude-amplitude, AM-AM, amplitude-phase, AM-PM, de l'amplificateur de puissance (330), et pour signaler la défaillance précoce au système informatique à distance, le micro-processeur (350) étant réactif à des instructions provenant du système informatique à distance pour reconfigurer l'amplificateur de puissance (330) en réponse à la défaillance précoce.

8. Système d'amplification de puissance reconfigurable selon la revendication 7, dans lequel les instructions comprennent une fourniture d'un correctif logiciel au micro-processeur (350) via le lien de communications (340).

9. Système d'amplification de puissance reconfigurable selon la revendication 7, dans lequel les instructions comprennent une réduction des fonctionnalités de l'amplificateur de puissance (330) par rapport à un fonctionnement normal.

10. Système d'amplification de puissance reconfigurable selon la revendication 7, dans lequel les instructions comprennent un téléchargement d'un nouveau système d'exploitation sur le micro-processeur (350) et une exécution d'un redémarrage à distance du système d'amplification de puissance reconfigurable (330), mettant ainsi à jour le system d'amplification de puissance reconfigurable (330).

11. Système d'amplification de puissance reconfigurable selon la revendication 7, comprenant en outre une entrée multivoies reconfigurable pour se connecter avec une pluralité de postes de base.

12. Système d'amplification de puissance reconfigurable selon la revendication 11, dans lequel l'entrée multivoies est en outre configurable pour se connecter avec une pluralité d'applications répéteurs.

13. Système d'amplification de puissance reconfigurable selon la revendication 7, dans lequel le détecteur surveille en outre de manière itérative des températures de jonctions de transistors.
